(19) Europäisches Patentamt
European Patent Office
Office européen des brevets

(11) **EP 4 495 077 A1**

(12) **EUROPÄISCHE PATENTANMELDUNG**

(43) Veröffentlichungstag:
**22.01.2025 Patentblatt 2025/04**

(21) Anmeldenummer: 23186427.3

(22) Anmeldetag: **19.07.2023**

(51) Internationale Patentklassifikation (IPC):
*C03C 3/087* (2006.01)   *C03C 3/095* (2006.01)
*C03C 3/097* (2006.01)   *C03C 10/14* (2006.01)

(52) Gemeinsame Patentklassifikation (CPC):
**C03C 3/087; C03C 3/095; C03C 3/097;
C03C 10/0027**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(71) Anmelder: **SCHOTT AG
55122 Mainz (DE)**

(72) Erfinder:
• **LANGER, Philipp
55122 Mainz (DE)**
• **KRÜGER, Susanne
55122 Mainz (DE)**
• **WEISS, Evelin
55122 Mainz (DE)**

(74) Vertreter: **Schott Corporate IP
Hattenbergstraße 10
55122 Mainz (DE)**

(54) **TRANSPARENTE LITHIUMALUMINIUMSILIKAT-GLASKERAMIK**

(57)    Die Erfindung betrifft eine transparente Lithiumaluminiumsilikat-Glaskeramik, sowie die Verwendung einer transparenten Lithiumaluminiumsilikat-Glaskeramik.

**Beschreibung**

Gebiet der Erfindung

Die Erfindung betrifft eine transparente Lithiumaluminiumsilikat-Glaskeramik, welche insbesondere für die Verwendung als Kochfläche in Kochgeräten geeignet ist sowie deren Verwendung.

Hintergrund der Erfindung

Glaskeramiken, insbesondere transparente Glaskeramiken sind seit vielen Jahren bekannt. Eine im Stand der Technik ebenfalls bekannte Variante einer solchen Glaskeramik stellen die Lithiumaluminiumsilikat (LAS)-Glaskeramiken dar, die entweder Hochquarz-Mischkristalle (HQMK), insbesondere für transparente Materialien, oder Keatit-Mischkristalle (KMK), insbesondere für transluzente oder opake Materialien, als Hauptkristallphase enthalten. Zur Herstellung solcher Glaskeramiken werden zunächst in für die Glasherstellung üblichen Verfahren Ausgangsgläser, sogenannte Grüngläser, hergestellt. Diese Grüngläser werden durch eine thermische Behandlung, die Keramisierung, in Glaskeramiken umgewandelt. Auf diese Weise erzeugte transparente Glaskeramiken können in vielfältigen Bereichen Anwendung finden. Insbesondere werden solche Glaskeramiken als Kochflächen verwendet. Ferner finden derartige Glaskeramiken Verwendung als Sichtscheibe für Kaminöfen, Backöfen, als Arbeitsplatte oder als Sicherheitsglas.

Die für die Verwendung als Kochfläche wesentliche Eigenschaft dieser Materialien ist, dass sie über eine sehr geringe thermische Ausdehnung in einem Temperaturbereich von Raumtemperatur bis 700 °C verfügen. Die niedrige thermische Ausdehnung bewirkt ihrerseits eine hohe Temperaturwechselbeständigkeit. Die thermische Ausdehnung wird durch die Kombination von Kristallphasen mit negativer thermischer Ausdehnung und einer amorphen Restglasphase mit positiver thermischer Ausdehnung eingestellt. Bei den bisher verwendeten Glaskeramiken wird dafür ein Lithiumoxidanteil von üblicherweise mehr als 3,6 bis 5,0 Gew.-% verwendet.

Aufgrund steigender Rohstoffpreise für Lithium ist es aus wirtschaftlichen Gründen vorteilhaft, den Anteil an Lithium in der Glaskeramik zu minimieren. Da Lithium aber eine der drei Hauptbestandteile in Lithiumaluminiumsilikat-Glaskeramiken ist, kann es nicht ohne Weiteres beliebig reduziert werden. Der Anteil an $Li_2O$ wirkt sich unmittelbar auf zentrale Eigenschaften der Glaskeramik wie beispielsweise die für die Herstellbarkeit wichtige Viskosität in der Schmelze und in der Heißformgebung oder auf die für die Verwendung als Kochfläche wichtige thermische Ausdehnung aus.

Die Preisentwicklung für Lithium ist kein neues Problem. In den vergangenen 20 Jahren hat sich der Preis für Lithium kontinuierlich erhöht. Trotz dieses seit langem bestehendem Bedürfnis weisen die meisten am Markt erhältlichen Glaskeramiken für Kochflächen ca. 3,8 oder mehr Gew.-% $Li_2O$ auf.

Glaskeramiken mit einem $Li_2O$-Anteil von weniger als 3,5 Gew.-% sind aus folgenden Dokumenten bekannt: WO 2012/010341 A1, EP 3502069 A1, US 2017050880, US 2020189965, US2020140322, US2021387899, WO2021/224412 A1. Diese Glaskeramiken weisen jedoch verschiedene Nachteile auf, beispielsweise eine reduzierte Temperaturwechselbeständigkeit oder eine schlechte Schmelzbarkeit des Grünglases.

Grundsätzliche Ansätze, mit denen Lithiumaluminiumsilikat-Glaskeramiken erzeugt werden können, die trotz eines geringen Gehaltes an $Li_2O$ die oben genannten Nachteile vermeiden, wurden durch die Anmelderin beispielsweise in der DE 20 2022 106 826 U1 beschrieben. Dabei werden auch Ansätze beschrieben, wie eine transparente Glaskeramik mit geringem Gehalt an $Li_2O$ erzeugt werden kann.

Für transparente Glaskeramiken ergeben sich dabei neben der zuvor beschriebenen Temperaturstabilität weitere besondere Anforderungen. Bei Verwendung einer transparenten Glaskeramik als Kochfläche wird die Glaskeramik üblicherweise mit einer farbigen Unterseitenbeschichtung versehen, sodass unter der Glaskeramik angeordnete Heizelemente und die zugehörige Elektronik von oberhalb der Glaskeramik nicht mehr sichtbar sind. Dabei besteht im Allgemeinen die Anforderung, dass die Farbwahrnehmung einer solchen Unterseitenbeschichtung durch einen Endnutzer durch die Glaskeramik nicht verfälscht wird. Ähnliche Anforderungen an die Glaskeramik ergeben sich auch bei Verwendung einer transparenten Glaskeramik als Sichtscheibe, da auch in diesem Fall eine Farbverfälschung bei Durchsicht durch die Sichtscheibe vermieden werden muss.

Unter einer transparenten Glaskeramik wird vorliegend wie üblich eine Glaskeramik mit geringer Lichtstreuung verstanden. Die Transmission einer solchen transparenten Glaskeramik kann über absorbierende, also färbende, Bestandteile in einem weiten Bereich eingestellt werden.

Aufgabe der Erfindung

Die Aufgabe der Erfindung besteht in der Bereitstellung einer transparenten Lithiumaluminiumsilikat-Glaskeramik, welche gute Schmelzeigenschaften des Grünglases aufweist und kostengünstig ist, ohne dass dadurch Einschränkungen in den Gebrauchseigenschaften entstehen. Ferner soll die erfindungsgemäße Glaskeramik eine möglichst geringe Verfälschung einer Farbwahrnehmung durch die Glaskeramik aufweisen.

Zu den guten Schmelzeigenschaften zählt dabei unter anderem, dass der Verarbeitungspunkt bei einer Temperatur von höchstens 1340 °C, vorzugsweise weniger als 1330 °C, besonders bevorzugt weniger als 1320 °C, liegt. Der Verarbeitungspunkt ist die Temperatur, bei der das Grünglas eine Viskosität von $10^4$ dPa*s aufweist. In der Nähe dieser Temperatur findet die Heißformgebung des Grünglases statt. Je höher die Temperatur bei der Heißformgebung ist, desto aufwändiger ist es, die durch das Glas in die Formgebungsmaschinen eingebrachte Wärme abzuführen. Bei Temperaturen von mehr als 1340 °C lässt sich dies nur erreichen, indem die Wärmemenge dadurch reduziert wird, dass der Durchsatz der Glasmenge reduziert wird. Dies ist jedoch wirtschaftlich nachteilig.

Bei Unterschreiten der sogenannten oberen Entglasungstemperatur während der Heißformgebung kann es zur unerwünschten spontanen Kristallisation (auch als "Entglasung" bezeichnet) kommen. Um dies zu verhindern, ist es vorteilhaft, wenn die obere Entglasungstemperatur wenigstens 10 K, vorzugsweise wenigstens 15 K, besonders bevorzugt wenigstens 20 K, ganz besonders bevorzugt wenigstens 30 K niedriger ist als der Verarbeitungspunkt.

Die Glaskeramik soll insbesondere allen Anforderungen für den Gebrauch als Kochfläche mit allen Arten von Heizelementen genügen. Dazu zählen insbesondere Strahlungs-, Induktions- und Gasheizelemente. Dies erfordert insbesondere eine ausreichend hohe Temperaturwechselbeständigkeit als auch eine hohe Temperatur-Langzeitbeständigkeit.

Zusammenfassung der Erfindung

Die Aufgabe der Erfindung wird gelöst durch den Gegenstand der unabhängigen Ansprüche. Bevorzugte Ausführungen und Weiterbildungen finden sich in den abhängigen Ansprüchen.

Die erfindungsgemäße transparente Lithiumaluminiumsilikat-Glaskeramik weist einen thermischen Ausdehnungskoeffizienten im Bereich von 20 °C bis 700 °C von -0,8 bis 1,5 ppm/K, einen Lichttransmissionsgrad $\tau_{vis}$ von mehr als 75 % bezogen auf eine Dicke von 4 mm und eine Buntheit C* von weniger als 10 bezogen auf eine Dicke von 4 mm auf. Die Glaskeramik enthält dabei in Gew.-% auf Oxidbasis die folgenden Bestandteile in den angegebenen Mengen:

| | |
|---|---|
| $SiO_2$ | 62 - 68 |
| $Al_2O_3$ | 19 - 24 |
| $Li_2O$ | 2,4 - 3,1 |
| BaO | > 2,5 |
| ZnO | > 2,5 |
| $ZrO_2$ | > 1,5 |
| $Na_2O$ | 0 - 1 |
| $K_2O$ | 0 - 1. |

Eine Glaskeramik mit einem entsprechenden thermischen Ausdehnungskoeffizienten weist sowohl eine hohe Temperaturwechselbeständigkeit als auch eine hohe thermische Langzeitstabilität auf. Dadurch ist sie für die Verwendung als Kochfläche mit allen Arten von Heizelementen geeignet. Der Ausdehnungskoeffizient beträgt wenigstens -0,8 ppm/K. Dabei bedeutet "ppm" "parts per million", also eine relative Größenänderung von $10^{-6}$ bei einer Temperaturänderung von 1 K. Negativere Werte der thermischen Ausdehnung werden vermieden. Bei einer negativen Ausdehnung, also einer Kontraktion, entstehen beim Aufheizen Zugspannungen in der Oberfläche der Glaskeramik. Bei einem Wert von weniger als -0,8 ppm/K können diese Spannungen bei typischen Betriebstemperaturen von Kochgeräten die mechanische Festigkeit der Kochfläche reduzieren. Eine thermische Ausdehnung von mehr als 1,5 ppm/K wird ebenfalls vermieden. Bei einer Ausdehnung von mehr als 1,5 ppm/K ist nicht sichergestellt, dass die Temperaturwechselbeständigkeit ausreichend hoch ist, um die Glaskeramik in Kochgeräten mit Strahlungsheizelementen einsetzen zu können.

In einer Weiterbildung der Erfindung beträgt der thermische Ausdehnungskoeffizient mindestens -0,6 ppm/K, -0,4 ppm/K, -0,2 ppm/K, 0,0 ppm/K, 0,2 ppm/K, 0,4 ppm/K, 0,6 ppm/K oder sogar 0,8 ppm/K. Außerdem beträgt der thermische Ausdehnungskoeffizient vorzugsweise maximal 1,4 ppm/K, 1,3 ppm/K, 1,2 ppm/K, 1,1 ppm/K, 1,0 ppm/K, 0,8 ppm/K oder sogar nur maximal 0,6 ppm/K.

In einer bevorzugten Ausführungsform der Erfindung beträgt der thermische Ausdehnungskoeffizient der Glaskeramik -0,8 bis 0,8 ppm/K, vorzugsweise -0,5 bis 0,5 ppm/K, besonders bevorzugt -0,3 bis 0,3 ppm/K. Solche Glaskeramiken sind besonders für Kochflächen in Kochgeräten mit Strahlungsheizelementen oder Induktionsheizelementen geeignet.

Bezüglich der angegebenen optischen Eigenschaften hinsichtlich der Transmission und der Buntheit der erfindungsgemäßen Glaskeramik bedeutet "bezogen auf eine Dicke von 4 mm", dass die entsprechenden Eigenschaften entweder an einer Probe mit einer Materialstärke von 4 mm bestimmt werden oder bei einer anderen Materialstärke bestimmt und auf eine Materialstärke von 4 mm umgerechnet werden. Bei Transmissionsangaben kann die Umrechnung mittels des Lambert-Beer-Gesetzes erfolgen.

Der Lichttransmissionsgrad $\tau_{vis}$ wird im Wellenlängenbereich 380 - 780 nm unter Verwendung von Licht der Normlichtart D65 und einem 2°-Beobachter gemäß den Vorgaben von DIN 5033 bestimmt. Dieser Wert entspricht der Helligkeit Y im CIExyY-Farbraum.

Die Buntheit C* wird gemäß der folgenden Formel aus den L*a*b*-Farbkoordinaten bestimmt:

$$C^* = \sqrt{(a^*)^2 + (b^*)^2}.$$

Die Farbkoordinaten a* und b* werden in bekannter Weise aus dem Transmissionsspektrum der Glaskeramik unter Verwendung von Normlicht der Normlichtart D65 und einem 2°-Beobachter bestimmt.

Glaskeramiken mit einem Lichttransmissionsgrad von mehr als 75 % bezogen auf eine Dicke von 4 mm sind besonders dafür geeignet, als Kaminsichtscheibe oder als Kochplatte verwendet zu werden. In Kaminen bewirkt diese Transmission, dass das Feuer besonders gut sichtbar ist. In Kochgeräten ermöglicht diese Transmission beispielsweise, dass Leuchtanzeigen mit relativ geringer Leuchtdichte wie beispielsweise LCD- oder OLED-Anzeigen besonders gut sichtbar sind. Bevorzugt weist die erfindungsgemäße Glaskeramik dabei einen Lichttransmissionsgrad $\tau_{vis}$ von mehr als 80 %, besonders bevorzugt mehr als 83 %, ganz besonders bevorzugt mehr als 85 % auf.

Die Buntheit C* von weniger als 10 bewirkt, dass die Farbe von Licht bei Durchtritt durch die Glaskeramik nur sehr geringfügig verändert wird. Dies ist beispielsweise bei der Verwendung als Kochfläche oder Kaminsichtscheibe von besonderer Bedeutung.

Die Buntheit einer Glaskeramik macht sich beispielsweise dann besonders bemerkbar, wenn die Glaskeramik zur Verwendung als Kochfläche mit einer weißen oder allgemein hellen Unterseitenbeschichtung versehen wird. Glaskeramiken in diesen Verwendungen sind häufig 4 mm dick. Licht, dass an einer rückseitigen Beschichtung reflektiert wird, durchläuft demnach eine optische Wegstrecke von 8 mm, so dass sich Farbverschiebungen durch eine Eigenfarbe der Glaskeramik stärker auswirken als bei kürzeren Wegstrecken. Für Kochflächen oder Kaminsichtscheiben mit einer weißen Beschichtung auf der Rückseite ist eine entsprechend geringe Buntheit deshalb besonders vorteilhaft. Bevorzugt weist die erfindungsgemäße Glaskeramik dabei eine Buntheit C* von weniger als 8 auf, besonders bevorzugt weniger als 6, ganz besonders bevorzugt weniger als 5.

Die erfindungsgemäße Glaskeramik enthält die folgenden Bestandteile in Gew.-%:

| | |
|---|---|
| $SiO_2$ | 62 - 68, |
| $Al_2O_3$ | 19 - 24 und |
| $Li_2O$ | 2,4 - 3,1. |

Die Komponenten $SiO_2$ und $Al_2O_3$ bilden in der Glaskeramik zusammen mit dem $Li_2O$ die Hauptbestandteile der Kristallphase. Zugleich bestimmen sie wesentlich die Glasbildungseigenschaften sowie die Viskosität des Grünglases.

Der $SiO_2$-Gehalt der erfindungsgemäßen Glaskeramik soll maximal 68 Gew.-% betragen, weil diese Komponente die Viskosität des Glases, insbesondere den Verarbeitungspunkt, stark erhöht. Für gutes Einschmelzen der Gläser und für niedrige Formgebungstemperaturen sind höhere Gehalte von $SiO_2$ unwirtschaftlich. Bei sehr hohen $SiO_2$-Anteilen von mehr als 68 Gew.-% kann es bei der Keramisierung zur Bildung von Keatit kommen. Dies führt zu einer starken Erhöhung der thermischen Ausdehnung und zu einer Verschlechterung der optischen Eigenschaften des Materials, insbesondere in Form einer Trübung. Der Mindestgehalt an $SiO_2$ soll dabei 62 Gew.-% betragen, weil dies für die geforderten Eigenschaften, wie z. B. chemische Beständigkeit und Temperaturbelastbarkeit vorteilhaft ist.

Vorzugsweise enthält die Glaskeramik wenigstens 63 Gew.-%, oder sogar 64 Gew.-% $SiO_2$. Je mehr $SiO_2$ die Glaskeramik enthält, desto besser ist ihre Temperaturbelastbarkeit und chemische Beständigkeit. Weiterhin enthält sie vorzugsweise höchstens 67 Gew.-%, höchstens 66 Gew.-%, oder sogar nur höchstens 65 Gew.-% $SiO_2$. Je weniger $SiO_2$ die Glaskeramik enthält, desto besser ist die Schmelzbarkeit und Verarbeitbarkeit des Grünglases in der Heißformgebung.

Der Gehalt an $Al_2O_3$ der erfindungsgemäßen Glaskeramik liegt im Bereich von 19 bis 24 Gew.-%. Ein höherer $Al_2O_3$-Anteil führt zu Problemen mit der Entglasung und der unerwünschten Bildung von Mullit. Deshalb sollen 24 Gew.-% nicht überschritten werden. Geringere Mengen als 19 Gew.-% an $Al_2O_3$ sind ungünstig für die Bildung der Hochquarz-Mischkristalle und fördern die Bildung unerwünschter Kristallphasen. Zudem hat sich gezeigt, dass sich geringe Gehalte an $Al_2O_3$ nachteilig auf die Buntheit der Glaskeramik auswirken.

Vorzugsweise enthält die Glaskeramik wenigstens 20 Gew.-% $Al_2O_3$, bevorzugt wenigstens 21 Gew.-% $Al_2O_3$. Je mehr $Al_2O_3$ die Glaskeramik enthält, desto besser ist ihre Temperaturbelastbarkeit. Weiterhin enthält sie vorzugsweise höchstens 23 Gew.-% $Al_2O_{3l}$, besonders bevorzugt höchstens 22 Gew.-% $Al_2O_3$. Je weniger $Al_2O_3$ die Glaskeramik enthält, desto besser ist die Schmelzbarkeit und Verarbeitbarkeit des Grünglases in der Heißformgebung.

Der Gehalt an Li$_2$O der erfindungsgemäßen Glaskeramik liegt im Bereich 2,4 - 3,1 Gew.-%. Es hat sich gezeigt, dass mit einem Li$_2$O-Gehalt in diesem Bereich in Kombination mit den übrigen Bestandteilen in den genannten Grenzen eine Glaskeramik mit einer hohen Temperaturwechselbeständigkeit und guten Schmelzbarkeit erzielt werden kann. Da Li$_2$O einen starken Einfluss auf die thermische Ausdehnung der Glaskeramik hat, wird Li$_2$O in Kombination mit den übrigen Bestandteilen der erfindungsgemäßen Glaskeramik in den oben genannten Grenzen gewählt, um die für die Erfindung geforderte Temperaturwechselbeständigkeit erzielen zu können. Zusätzlich wirkt sich ein Anteil von mehr als 2,4 Gew.-% Li$_2$O positiv auf die Herstellbarkeit der Glaskeramik aus, da dies den elektrischen Widerstand der Glasschmelze reduziert, die Viskosität reduziert und dadurch auch den Verarbeitungspunkt absenkt. Durch eine reduzierte Viskosität der Glasschmelze kann auch die Effizienz der Läuterung verbessert werden. Eine verbesserte Läuterung führt zu weniger Produktionsausschuss aufgrund von Blasenbildung im Grünglas. Ferner reduziert Li$_2$O auch die Tendenz des Grünglases zur Entglasung.

In einer bevorzugten Ausführungsform enthält die Glaskeramik wenigstens 2,5 Gew.-%, 2,6 Gew.-%, oder sogar 2,7 Gew.-% Li$_2$O.

Als Quelle für Lithium zur Herstellung von Glaskeramik werden in der Regel natürliche Mineral-Rohstoffe wie beispielsweise Spodumen oder Petalit verwendet oder alternativ synthetisch hergestelltes Li$_2$CO$_3$.

In einer bevorzugten Ausführungsform enthält die Glaskeramik Hochquarz-Mischkristalle als Hauptkristallphase. "Hauptkristallphase" bedeutet, dass die Glaskeramik in Volumenanteilen mehr Hochquarz-Mischkristall als Keatit-Mischkristall und andere Kristallphasen enthält. In einer Weiterbildung dieser Ausführungsform enthält die Glaskeramik < 10 Vol.-%, bevorzugt < 5 Vol.-%, besonders bevorzugt < 3 Vol.-% Keatit-Mischkristall. Die Angabe Vol.-% bezieht sich dabei auf das Volumen der Glaskeramik. Die Volumenanteile werden mittels Rietveld-Analyse aus Röntgenbeugungsspektren bestimmt.

Keatit-Mischkristalle haben allgemein eine höhere thermische Ausdehnung als Hochquarz-Mischkristalle. Deshalb ist ein hoher Anteil Hochquarz-Mischkristalle bei einem gleichzeitig niedrigen Anteil an Keatit-Mischkristallen besonders vorteilhaft für einen geringen thermischen Ausdehnungskoeffizienten der Glaskeramik. Ein geringer thermischer Ausdehnungskoeffizient verbessert zudem die Temperaturwechselbeständigkeit der Glaskeramik. Gleichzeitig verursachen Keatit-Mischkristalle aufgrund ihrer üblicherweise großen Kristallitgröße eine stärkere Streuung von Licht, sodass ein zu hoher Anteil an Keatit die optischen Eigenschaften der Glaskeramik negativ beeinflusst. Auch aus diesem Grund sollte der Gehalt an Keatit in der Kristallphase so gering wie möglich gehalten werden.

Neben den zuvor genannten Mengen an SiO$_2$, Al$_2$O$_3$ und Li$_2$O enthält die erfindungsgemäße Glaskeramik mehr als 2,5 Gew.-% ZnO, bevorzugt mehr als 2,6 Gew.-%, mehr als 2,7 Gew.-%, mehr als 2,8 Gew.-%, oder mehr als 2,9 Gew.-%, besonders bevorzugt mehr als 3,0 Gew.-%, ganz besonders bevorzugt mehr als 3,2 Gew.-%. Zuvor wurde bereits ausgeführt, dass Li$_2$O dazu beiträgt, den thermischen Ausdehnungskoeffizienten der Glaskeramik zu reduzieren. Eine Absenkung des Gehalts an Li$_2$O gegenüber des im Stand der Technik üblicherweise für transparente Glaskeramiken verwendeten Anteils führt daher zu einer geringeren Reduzierung des thermischen Ausdehnungskoeffizienten des Hochquarz-Mischkristalls in der Glaskeramik, sodass ggf. die für die Anwendung als Kochfläche erforderlichen Ausdehnungskoeffizienten nicht erreicht werden können. ZnO trägt jedoch, ähnlich wie Li$_2$O ebenfalls zur Reduzierung des thermischen Ausdehnungskoeffizienten bei, sodass der Effekt einer Reduzierung des Gehalts an Li$_2$O zumindest teilweise durch eine Steigerung des Gehalts an ZnO auf einen Wert von mehr als 2,5 Gew.-% ausgeglichen werden kann.

Ferner reduziert ZnO den Verarbeitungspunkt und die obere Entglasungstemperatur der Glaskeramik. ZnO kann allerdings insbesondere in Kombination mit hohen Mengen an Al$_2$O$_3$ zur unerwünschten Bildung von Gahnit-Kristallen führen. Deshalb wird die Menge in der Glaskeramik vorzugsweise auf 6,0 Gew.-% begrenzt. Zusätzlich hat sich empirisch gezeigt, dass Glaskeramiken mit sehr hohen Mengen an ZnO zur Ausbildung von unerwünschten Kristallen an der Oberfläche der Glaskeramik neigen. Deshalb wird die Menge an ZnO vorzugsweise auf Mengen von höchstens 5,6 Gew.-%, 5,3 Gew.-%, 5,0 Gew.-%, 4,6 Gew.-%, 4,3 Gew.-%, 4,0 Gew.-% oder sogar 3,7 Gew.-% begrenzt.

Ferner führt ein zu hoher Gehalt an ZnO zu einem erhöhten Brechwertunterschied zwischen Kristall- und Restglasphase in der Glaskeramik, sodass eine entsprechende Glaskeramik einfallendes Licht verstärkt streut. Folglich kann eine Steigerung des Gehalts an ZnO die Transmission und Buntheit einer Glaskeramik negativ beeinflussen.

Um diesem Effekt entgegenzuwirken, enthält die erfindungsgemäße Glaskeramik ferner mehr als 2,5 Gew.-% BaO. Ein erhöhter Anteil an BaO reduziert die Tendenz der Glaskeramik zur Streuung von einfallendem Licht, da der Brechwert der Restglasphase bei gleichen Kristallitgrößen mit der Zugabe von BaO an den Brechwert der kristallinen Phase der Glaskeramik angeglichen werden kann. Dieser Effekt zeigt sich für die Anteile von Li$_2$O und ZnO in den zuvor genannten Grenzen, insbesondere bei gleichzeitig niedrigem Gehalt an SrO und CaO in der Glaskeramik. BaO bewirkt ferner, ähnlich wie Li$_2$O, eine Absenkung der Viskosität der Glasschmelze und somit eine Reduzierung des Verarbeitungspunktes. Um die Schmelzbarkeit des Grünglases zu verbessern, ist es vorteilhaft, wenn die Glaskeramik in Kombination mit den oben genannten Mengen an Li$_2$O mehr als 2,6 Gew.-%, mehr als 2,7 Gew.-%, mehr als 2,8 Gew.-%, mehr als 2,9 Gew.-%, oder sogar mehr als 3,0 Gew.-% BaO enthält. BaO trägt in der Glaskeramik auch maßgeblich zur Verbesserung des Entglasungsverhaltens bei der Heißformgebung des Grünglases bei. Dabei ist der Gehalt an BaO bevorzugt auf weniger als 4,0 Gew.-%, weniger als 3,9 Gew.-%, weniger als 3,8 Gew.-%, weniger als 3,7 Gew.-%, weniger als 3,6 Gew.-

%, weniger als 3,5 Gew.-%, weniger als 3,4 Gew.-%, weniger als 3,3 Gew.-%, oder sogar weniger als 3,2 Gew.-% beschränkt.

Des Weiteren enthält die erfindungsgemäße Glaskeramik mehr als 1,5 Gew.-% $ZrO_2$. $ZrO_2$ fungiert in der Glaskeramik unter anderem als Keimbildner und kann als solcher mit weiteren Bestandteilen einer Glaskeramik, wie $SnO_2$ und $TiO_2$ zusammenwirken. Ein Gehalt von mehr als 1,5 Gew.-% $ZrO_2$ und ist dabei vorteilhaft, um die Keimbildung zu verbessern.

In einer Weiterbildung der Erfindung kann dabei die Menge an $ZrO_2$ auf Werte von 3,0 Gew.-% begrenzt werden, da $ZrO_2$ das Einschmelzverhalten des Gemenges verschlechtert. Zusätzlich kann $ZrO_2$ zur Entglasung bei der Heißformgebung führen. Dabei kann es zur unerwünschten Bildung von Zr-haltigen Kristallphasen, beispielsweise Baddeleyit kommen. Vorzugsweise enthält die Glaskeramik wenigstens >1,6 Gew.-%, besonders bevorzugt >1,7 Gew.-% $ZrO_2$, ganz besonders bevorzugt >1,8 Gew.-%. Weiter enthält sie vorzugsweise höchstens 2,9 Gew.-%, 2,8 Gew.-%, 2,6 Gew.-%, 2,5 Gew.-%, 2,4 Gew.-%, 2,3 Gew.-%, 2,2 Gew.-%, 2,1 Gew.-%, oder sogar nur 2,0 Gew.-% $ZrO_2$. In diesen Mengen lässt sich ein besonders guter Kompromiss aus positivem Beitrag zur Keimbildung bei noch akzeptabler Verschlechterung von Schmelzbarkeit und Heißformgebung erzielen. Durch eine Optimierung des Gehalts an $ZrO_2$, insbesondere im Hinblick auf den später noch diskutierten Gehalt der Glaskeramik an $TiO_2$ kann dabei ferner eine schnellere Keramisierung des Grünglases ermöglicht werden. Eine schnellere Keramisierung bei vorhergehender ausreichender Keimbildung führt zu einer geringeren Kristallitgröße in der Glaskeramik und mithin zu einer geringeren Streuung von Licht. Ein Gehalt an $Na_2O$ von 0 - 1 Gew.-% in der erfindungsgemäßen Glaskeramik verbessert die Schmelzbarkeit und das Entglasungsverhalten bei der Formgebung des Glases zusätzlich. Ferner kann $Na_2O$ die elektrische Leitfähigkeit der Schmelze erhöhen. Dies erleichtert die Einkopplung von Energie durch elektrische Heizungen in der Schmelzwanne. Die Gehalte werden jedoch begrenzt, weil es nicht in die Kristallphasen eingebaut wird, sondern im Wesentlichen in der Restglasphase der Glaskeramik verbleibt. Zu hohe Gehalte beeinträchtigen das Kristallisationsverhalten bei der Umwandlung des kristallisierbaren Ausgangsglases in die Glaskeramik, hier insbesondere zu Lasten schneller Keramisierungsgeschwindigkeiten. Eine Folge hiervon können erhöhte Kristallitgrößen bei bevorzugter schneller Keramisierung in der Glaskeramik sein, die sich wiederum ungünstig auf das Streuverhalten der Glaskeramik auswirken. Außerdem wirken sich höhere Gehalte ungünstig auf die Zeit-/Temperaturbelastbarkeit der Glaskeramik aus. Deshalb enthält die Glaskeramik vorzugsweise >0,1 - 1 Gew.-% oder 0,2 - 0,8 Gew.-% oder sogar 0,3 - 0,6 Gew.-% $Na_2O$.

$K_2O$ in Mengen von 0 - 1 Gew.-% bewirkt in der erfindungsgemäßen Glaskeramik eine Verbesserung der Schmelzbarkeit und des Entglasungsverhaltens bei der Formgebung des Glases. $K_2O$ kann ebenfalls zusätzlich die elektrische Leitfähigkeit der Schmelze erhöhen. Dies erleichtert die Einkopplung von Energie durch elektrische Heizungen in der Schmelzwanne. Die Gehalte werden jedoch begrenzt, weil es nicht in die Kristallphasen eingebaut wird, sondern im Wesentlichen in der Restglasphase der Glaskeramik verbleibt. Zu hohe Gehalte beeinträchtigen das Kristallisationsverhalten bei der Umwandlung des kristallisierbaren Ausgangsglases in die Glaskeramik, hier insbesondere zu Lasten schneller Keramisierungsgeschwindigkeiten. Analog zu den vorstehenden Ausführungen bzgl. $Na_2O$ wirkt sich auch hier eine zu hohe Keramisierungsgeschwindigkeit und mithin eine erhöhte Kristallitgröße in der Glaskeramik nachteilig auf das Streuverhalten der Glaskeramik aus. Außerdem wirken sich höhere Gehalte ungünstig auf die Zeit-/Temperaturbelastbarkeit der Glaskeramik aus.

Diese Eigenschaften können weiter verbessert werden, wenn $K_2O$ in Mengen von höchstens 0,8 Gew.-%, 0,6 Gew.-%, 0,5 Gew.-%, 0,4 Gew.-%, oder sogar 0,3 Gew.-% in der Glaskeramik enthalten ist. In einer besonderen Ausgestaltung kann ferner vorgesehen sein, dass die Glaskeramik bis auf unvermeidbare Verunreinigungen frei von $K_2O$ ist.

In einer Weiterbildung der Erfindung ist ferner vorgesehen, dass die Glaskeramik bis auf unvermeidbare Verunreinigungen frei von $Cr_2O_3$, $V_2O_5$, $MnO_2$ und $MoO_3$ ist. $V_2O_5$ und MoOs werden üblicherweise als Hauptfärbemittel zur Färbung von volumengefärbten Glaskeramiken eingesetzt, während $Cr_2O_3$ und $MnO_2$ häufig zur unterstützenden Färbung eingesetzt werden. Die vorstehend genannten Färbemittel und insbesondere $V_2O_5$ färben in Glaskeramiken generell schon in geringen Mengen sehr intensiv, weswegen die Gehalte der vorstehend genannten Komponenten in der erfindungsgemäßen Glaskeramik so gering wie möglich gehalten werden sollten, um die erfindungsgemäße Transmission und Buntheit der Glaskeramik zu gewährleisten. Dabei kommen diese Komponenten unter anderem als Verunreinigungen in Rohstoffen des Gemenges oder als Komponenten in Scherben vor, die dem Gemenge zur Verbesserung der Schmelzeigenschaften hinzugefügt werden. Unter einer "unvermeidbaren Verunreinigung" wird dabei ein Gehalt von weniger als 20 ppm, insbesondere weniger als 10 ppm, insbesondere weniger als 5 ppm der jeweiligen Komponenten in der Zusammensetzung verstanden. Ferner ist die Glaskeramik bevorzugt bis auf unvermeidbare Verunreinigungen auch frei von Ce, Ni, Cu, Co, W und/oder S bzw. deren Oxiden.

In einer bevorzugten Weiterbildung der Erfindung enthält die Glaskeramik weniger als 3,0 Gew.-% $TiO_2$. $TiO_2$ trägt zusammen mit $ZrO_2$ maßgeblich zur Keimbildung bei. Die Menge an $TiO_2$ wird auf Werte von höchstens 3,0 Gew.-% begrenzt. $TiO_2$ kann in größeren Mengen zu einer Entglasung bei der Heißformgebung führen. Zusätzlich kann es zu einer unerwünschten Erhöhung des Brechungsindexes der Restglasphase führen. Vorzugsweise enthält die Glaskeramik wenigstens 1 Gew.-%, 1,5 Gew.-%, 2,0 Gew.-%, >2,1 Gew.-% $TiO_2$. Gleichzeitig enthält sie vorzugsweise höchstens 2,7 Gew.-%, 2,5 Gew.-% oder sogar nur höchstens 2,4 Gew.-% $TiO_2$. Bei höheren Anteilen an $TiO_2$ läuft die Keimbildung schneller ab. Dadurch kann die Keramisierungszeit der Glaskeramik reduziert werden. Niedrigere Anteile bewirken eine Stabilisierung des Keramisierungsprozesses und beugen einer unbeabsichtigten Entglasung während der Heißformgebung des Grünglases vor. Zusammenfassend ist der Gehalt an $TiO_2$ nach oben begrenzt, um die färbende Wirkung von $TiO_2$ für die optischen Eigenschaften der Glaskeramik so gering wie möglich zu halten. Gleichzeitig sollte der Gehalt an $TiO_2$ jedoch auch nicht zu gering gewählt werden, sodass weiterhin eine hinreichende Keimbildung und kurze Keramisierungszeiten gewährleistet sind. Dabei kann durch den Einsatz der oben genannten Mengen an $ZrO_2$ der Anteil $TiO_2$ als weiterer Keimbildner reduziert und somit eine Glaskeramik mit reduzierter Buntheit hergestellt werden.

In einer Weiterbildung der Erfindung enthält die Glaskeramik weniger als 0,05 Gew.-% $Fe_2O_3$, bevorzugt weniger als 0,04 Gew.-%, besonders bevorzugt weniger als 0,03 Gew.-%, ganz besonders bevorzugt weniger als 0,02 Gew.-%. Ähnlich wie $V_2O_5$, $Cr_2O_3$, $MnO_2$ und $MoOs$ wirkt auch $Fe_2O_3$ in der Glaskeramik färbend. Aus diesem Grund ist es für eine transparente Glaskeramik vorteilhaft, wenn der Gehalt an $Fe_2O_3$ auf die oben genannten Werte beschränkt ist. So weisen beispielsweise Glaskeramiken, die $Fe_2O_3$ als Färbemittel enthalten, häufig einen Gelbstich auf. Dies kann beispielsweise bei Glaskeramiken der Fall sein, die gleichzeitig $TiO_2$ und über Verunreinigung der Rohstoffe eingeschlepptes $Fe_2O_3$ enthalten. Wenn solche Glaskeramiken beispielsweise mit weißen Unterseitenbeschichtungen versehen werden, weisen diese Unterseitenbeschichtungen einen deutlich wahrnehmbaren Gelbstich auf.

Ferner wirkt sich $Fe_2O_3$ nicht nur im sichtbaren Spektralbereich auf die Transmission aus, sondern auch im Nahinfraroten bis ca. 3 $\mu m$ Wellenlänge. Damit hat $Fe_2O_3$ nicht nur einen Einfluss auf die Erzielbarkeit bestimmter Farben oder die Darstellbarkeit von Farbanzeigen. Die Absorption im Nahinfraroten bestimmt, wieviel Wärmeenergie die Glasschmelze in der Wanne absorbieren kann. Sie bestimmt darüber, wie viel Heizleistung von Strahlungsheizelementen durch die Glaskeramik hindurchtreten kann. Ferner bestimmt sie, ob und welche Infrarotsensoren in einem Kochfeld verwendet werden können. Solche Sensoren können beispielsweise als optische Berührungssensoren oder als Infrarot-Empfänger für kabellose Datenübertragung ausgebildet sein.

Es wird an dieser Stelle darauf hingewiesen, dass im Rahmen der vorliegenden Offenbarung die Komponenten des Glases in der Form angegeben werden, wie sie üblicherweise mittels Analyse erhalten werden. Dabei wird üblicherweise die Komponente in der stabilen, zumeist in der höchsten, Oxidationsstufe angegeben. Es wird allerdings darauf hingewiesen, dass dies nicht zwingend der Form entspricht, in welcher die Komponente auch tatsächlich vorliegt.

Beispielsweise kann das Eisen in einem oxidischen Glas sowohl zweiwertig als auch dreiwertig vorliegen, also als $Fe^{2+}$ bzw. $FeO$ oder als $Fe^{3+}$ bzw. als $Fe_2O_3$. Die Angaben zu den Gehalten entsprechender Komponenten im Rahmen der vorliegenden Offenbarung beziehen sich also auf übliche Angaben der Analyse, wobei allerdings verstanden wird, dass die Komponente auch in von der "idealen", üblicherweise angegebenen Oxidationsstufe abweichender Form vorliegen kann.

In einer Weiterbildung der Erfindung enthält die Glaskeramik weniger als 1,2 Gew.-% $MgO$, bevorzugt weniger als 1,0 Gew.-%, besonders bevorzugt weniger als 0,8 Gew.-%, weniger als 0,7 Gew.-%, weniger als 0,6 Gew.-%, ganz besonders bevorzugt weniger als 0,5 Gew.-%. $MgO$ hat dabei einen positiven Einfluss auf die Schmelzbarkeit und das Entglasungsverhalten der Glaskeramik, führt jedoch in zu hohen Mengen zu einer Erhöhung der Buntheit der Glaskeramik und zur Erhöhung des thermischen Ausdehnungskoeffizienten der Hochquarz-Mischkristallphase. Daher hat es sich für eine farblose, transparente Glaskeramik als vorteilhaft erwiesen, den Gehalt an $MgO$ auf die zuvor genannten Grenzen zu beschränken.

Nach einer weiteren Weiterbildung der Erfindung ist ferner vorgesehen, dass die transparente Lithiumaluminiumsilikat-Glaskeramik weniger als 1,2 Gew.-% $CaO$ enthält, bevorzugt weniger als 1,0 Gew.-%, besonders bevorzugt weniger als 0,8 Gew.-%, ganz besonders bevorzugt weniger als 0,5 Gew.-%. $CaO$ wirkt sich dabei vorteilhaft für das Entglasungsverhalten der Glaskeramik aus. Allerdings hat es sich für eine farblose, transparente Glaskeramik als vorteilhaft erwiesen, den Gehalt an $CaO$ auf die vorstehenden Werte zu begrenzen, da $CaO$ zu einer Vergrößerung der Kristallitgröße in der Glaskeramik beiträgt. Mit einer Vergrößerung der Kristallitgröße geht wiederum eine verstärkte Streuung und mithin schlechtere optische Eigenschaften der Glaskeramik einher.

In einer Weiterbildung der Erfindung enthält die Glaskeramik weniger als 0,2 Gew.-% $SnO_2$., bevorzugt weniger als 0,15 Gew.-%, besonders bevorzugt weniger als 0,1 Gew.-% $SnO_2$. $SnO_2$ unterstützt die Läuterung des Grünglases. Eine Glaskeramik mit den vorstehend genannten Mengen an $SnO_2$ zeichnet sich daher durch besonders wenige Defekte aufgrund von eingeschlossenen Gasblasen aus. Dabei wirkt sich $SnO_2$ in Kombination mit den anderen Bestandteilen der erfindungsgemäßen Glaskeramik zusätzlich positiv auf die Keimbildung aus. Die Menge von weniger als 0,2 Gew.-% soll aber nicht überschritten werden, da $SnO_2$ sich negativ auf die optischen Eigenschaften der Glaskeramik auswirkt und insbesondere eine Erhöhung der Buntheit der Glaskeramik bewirken kann. Höhere Gehalte an $SnO_2$ führen zudem zur unerwünschten Kristallisation von Sn-haltigen Kristallphasen, beispielsweise Kassiterit, an den Kontaktmaterialien (z. B. Pt/Rh) bei der Formgebung und diese führt zu einer weiteren Verschlechterung der optischen Eigenschaften der Glaskeramik.

Zur Unterstützung der Läuterung des Grünglases kann dabei zusätzlich zu dem oben genannten Gehalt an $SnO_2$ ein Anteil von bis zu 2 Gew.-% $As_2O_3$ und/oder $Sb_2O_3$ enthalten sein. Dabei hat es sich als vorteilhaft erwiesen, den Gehalt

an $SnO_2$ so weit wie möglich abzusenken, da $SnO_2$, wie vorstehend bereits ausgeführt, neben seiner positiven Wirkung auf die Läuterung des Grünglases eine negative Wirkung auf die optischen Eigenschaften der Glaskeramik haben kann. Dies liegt unter anderem darin begründet, dass $SnO_2$ mit $TiO_2$ eine zusätzliche Absorptionsbande für einfallendes Licht ausbilden kann, wodurch es zu einer Rotverschiebung des transmittierten Lichts kommt. Weiterhin kann $SnO_2$ dazu beitragen, den Anteil $Fe^{2+}$ im $Fe_2O_3$ zu erhöhen, wodurch es zur verstärkten Färbung im Zusammenhang mit $TiO_2$ kommt.

Da $As_2O_3$ und $Sb_2O_3$ im Wesentlichen gleich wirken, können sie sowohl einzeln als auch in Kombination in der Glaskeramik enthalten sein. In allen Fällen soll die Menge bevorzugt jeweils 2 Gew.-% nicht überschreiten. Die Formulierung "$As_2O_3$ und/oder $Sb_2O_3$" bedeutet in diesem Kontext, dass die beiden Komponenten einzeln oder in Kombination in der entsprechenden Menge enthalten sein können. Dementsprechend ist nach einer weiteren Weiterbildung der Erfindung vorgesehen, dass die Glaskeramik bis auf unvermeidbare Verunreinigungen frei von $SnO_2$ ist und 0,5 Gew.-% bis 1,5 Gew.-% $As_2O_3$ und/oder $Sb_2O_3$ enthält. Eine solche Läuterung, die vollständig ohne $SnO_2$ erfolgt und mithin den oben genannten Einfluss von $SnO_2$ auf die optischen Eigenschaften der Glaskeramik vermeidet, ist dabei besonders vorteilhaft zur Herstellung einer transparenten und farbneutralen Glaskeramik. Anders als $SnO_2$ haben $As_2O_3$ und $Sb_2O_3$ keinen Einfluss auf die Farbe der Glaskeramik, da sie nicht so stark reduzierend auf $Fe_2O_3$ wie $SnO_2$ wirken und auch nicht zu einer verstärkten Färbung im Zusammenhang mit $TiO_2$ führen.

In einer Weiterbildung der Erfindung ist ferner vorgesehen, dass die transparente Lithiumaluminiumsilikat-Glaskeramik 0,01 - 0,07 Gew.-% $Nd_2O_3$, bevorzugt 0,03 - 0,06 Gew.-% $Nd_2O_3$ enthält. $Nd_2O_3$ kann dabei insbesondere bei einer Läuterung mit $SnO_2$ dazu beitragen, eine durch das $SnO_2$ verursachte Buntheit der Glaskeramik zu kompensieren. Dabei ist die Hinzunahme von $Nd_2O_3$ insbesondere bei Gehalten an $SnO_2$ von mehr als 0,1 Gew.-% vorteilhaft zur Herstellung einer weitgehend farbneutralen Glaskeramik.

In Glaskeramiken mit einem Gehalt an $Fe_2O_3$ und $TiO_2$ in den zuvor beschriebenen Grenzen kann eine Zugabe von $Nd_2O_3$ ferner dazu beitragen, einen durch $Fe_2O_3$ und $TiO_2$ verursachten Gelbstich zu reduzieren oder zu beheben, wobei der Lichttransmissionsgrad dabei nur geringfügig beeinflusst wird. Dieser Effekt beruht auf schmalen Absorptionsbanden des $Nd_2O_3$ im sichtbaren Spektralbereich bei Wellenlängen von 513, 526, 575, 585 und 745 nm und ist zur Herstellung einer transparenten, farbneutralen Glaskeramik besonders vorteilhaft.

Zusammenfassend kann dementsprechend die Läuterung der Glaskeramik durch Zugabe von $SnO_2$ allein, durch eine Kombination von $SnO_2$ sowie $As_2O_3$ und/oder $Sb_2O_3$, oder durch reine Läuterung mittels $As_2O_3$ und/oder $Sb_2O_3$, also in Abwesenheit von $SnO_2$, erfolgen.

In einer Weiterbildung der Erfindung enthält die Glaskeramik die nachfolgenden Bestandteile in Gew.-% auf Oxidbasis:

| | |
|---|---|
| $SiO_2$ | 62 - 67 |
| $Al_2O_3$ | 19 - 23 |
| $Li_2O$ | 2,4 - 3,1 |
| $Na_2O$ | 0 - 1 |
| $K_2O$ | 0 - 1 |
| $MgO$ | 0 - 1 |
| $CaO$ | 0 - 1,2 |
| $BaO$ | > 2,5 |
| $ZnO$ | > 2,5 |
| $TiO_2$ | < 3,0 |
| $ZrO_2$ | > 1,5. |

Ferner kann eine solche Glaskeramik auch SrO enthalten, wobei der Gehalt an SrO hauptsächlich aus Verunreinigungen der Rohstoffe zur Herstellung der Glaskeramik stammt. SrO trägt dabei unter anderem zur Streuung von Licht durch die Glaskeramik bei. Daher ist es vorteilhaft, den Gehalt an SrO in der Glaskeramik so gering wie möglich zu halten.

Die folgende Tabelle enthält drei weitere Weiterbildungen einer Zusammensetzung der erfindungsgemäßen Glaskeramik in Gew.-% auf Oxidbasis:

| | bevorzugt | besonders bevorzugt | am meisten bevorzugt |
|---|---|---|---|
| $Si_2O$ | 62 - 67 | 63 - 66 | 64 - 66 |
| $Al_2O_3$ | 19 - 22 | 19 - 22 | 19 - 22 |

(fortgesetzt)

|  | bevorzugt | besonders bevorzugt | am meisten bevorzugt |
|---|---|---|---|
| $Li_2O$ | 2,5 - 3,0 | 2,6 - 2,9 | 2,6 - 2,8 |
| $Na_2O$ | 0,1 - 0,8 | 0,2 - 0,7 | 0,3 - 0,6 |
| $K_2O$ | < 0,8 | < 0,4 | < 0,1 |
| $MgO$ | 0 - 0,7 | 0 - 0,6 | 0,1 - 0,6 |
| $CaO$ | < 1,0 | < 0,5 | < 0,1 |
| $BaO$ | > 2,5 | 2,5 - 4,5 | 2,5 - 4,0 |
| $ZnO$ | > 2,5 | 2,6 - 4,0 | 2,7 - 3,7 |
| $TiO_2$ | 1,5 - 2,7 | 2,0 - 2,5 | 2,1 - 2,4 |
| $ZrO_2$ | 1,5 - 3,0 | 1,6 - 2,8 | 1,6 - 2,0 |

Insbesondere können die vorstehenden Zusammensetzungen bis auf unvermeidbare Verunreinigungen frei von $K_2O$ sein.

Drei hierzu alternative Weiterbildungen einer Zusammensetzung der erfindungsgemäßen Glaskeramik in Gew.-% auf Oxidbasis sind nachfolgend angegeben:

|  | bevorzugt | besonders bevorzugt | am meisten bevorzugt |
|---|---|---|---|
| $Si_2O$ | 62 - 67 | 63 - 66 | 63 - 65 |
| $Al_2O_3$ | 19 - 22 | 20 - 22 | 20,5 - 21,5 |
| $Li_2O$ | 2,5 - 3,1 | 2,7 - 3,1 | 2,9 - 3,1 |
| $Na_2O$ | 0,1 - 0,8 | 0,15 - 0,7 | 0,25 - 0,4 |
| $K_2O$ | 0,1 - 0,8 | 0,1 - 0,6 | 0,15 - 0,3 |
| $MgO$ | 0 - 0,7 | 0,2 - 0,5 | 0,3 - 0,45 |
| $CaO$ | 0 - 1,0 | 0,2 - 0,7 | 0,35 - 0,55 |
| $BaO$ | > 2,5 | > 2,8 | 2,9 - 3,4 |
| $ZnO$ | > 2,6 | > 2,6 - 3,5 | > 2,6 - 3,0 |
| $TiO_2$ | 1,0 - 2,7 | 1,5 - 2,5 | 2,0 - 2,4 |
| $ZrO_2$ | 1,5 - 3,0 | 1,6 - 2,8 | 1,6 - 2,0 |

Drei weitere Weiterbildungen einer Zusammensetzung der erfindungsgemäßen Glaskeramik in Gew.-% auf Oxidbasis sind nachfolgend angegeben:

|  | bevorzugt | besonders bevorzugt | am meisten bevorzugt |
|---|---|---|---|
| $Si_2O$ | 62 - 67 | 63 - 66 | 63,5 - 65,5 |
| $Al_2O_3$ | 19 - 22 | 20 - 22 | 20,5 - 21,5 |
| $Li_2O$ | 2,4 - 3,1 | 2,4 - 3,1 | 2,4 - 3,1 |
| $Na_2O$ | 0,1 - 0,8 | 0,15 - 0,6 | 0,2 - 0,45 |
| $K_2O$ | 0,1 - 0,8 | 0,1 - 0,6 | 0,15 - 0,6 |
| $MgO$ | 0 - 0,7 | 0 - 0,5 | > 0 - 0,45 |
| $CaO$ | 0 - 1,0 | 0,4 - 1,0 | 0,8 - 1,0 |
| $BaO$ | > 2,5 | > 2,5 - 3,2 | > 2,5 - 2,7 |
| $ZnO$ | > 2,5 | 2,6 - 3,5 | > 2,6 - 3,4 |

(fortgesetzt)

|  | bevorzugt | besonders bevorzugt | am meisten bevorzugt |
|---|---|---|---|
| $TiO_2$ | 1,0 - 2,7 | 1,5 - 2,5 | 2,0 - 2,4 |
| $ZrO_2$ | 1,5 - 3,0 | 1,6 - 2,8 | 1,6 - 2,0 |

Neben den konkret benannten Komponenten der vorstehenden Zusammensetzungen, können die entsprechenden Glaskeramiken auch weitere Komponenten, insbesondere Läutermittel enthalten.

Dabei kann die Läuterung von Grüngläsern auf Grundlage der vorstehend genannten Zusammensetzung sowohl mittels $SnO_2$, mittels einer Kombination aus $SnO_2$ und $As_2O_3$ und/oder $Sb_2O_3$ oder nur mittels $As_2O_3$ und/oder $Sb_2O_3$, also in Abwesenheit von $SnO_2$, erfolgen. Dabei können die zuvor benannten Grenzwerte für den Gehalt der jeweiligen Komponenten in der Zusammensetzung angesetzt werden.

In einer bevorzugten Weiterbildung der Erfindung ist ferner vorgesehen, dass die transparente Lithiumaluminiumsilikat-Glaskeramik in der Hochquarz-Mischkristallphase eine Kristallitgröße von weniger als 80 nm, bevorzugt weniger als 70 nm, besonders bevorzugt weniger als 60 nm und ganz besonders bevorzugt weniger als 50 nm aufweist. Die Kristallitgröße hat dabei direkten Einfluss auf die optischen Eigenschaften der Glaskeramik. So führt eine zu große Kristallitgröße zu einer verstärkten Lichtstreuung in der Glaskeramik, die sich als Trübung der Glaskeramik zeigt.

In einer weiteren Weiterbildung der Erfindung liegt das Verhältnis von $Al_2O_3$ zu $TiO_2$ im Bereich 7 bis 12, bevorzugt im Bereich 8 bis 11, besonders bevorzugt im Bereich 8,5 bis 10,5. Es hat sich gezeigt, dass sich das Verhältnis von $Al_2O_3$ zu $TiO_2$ in diesem Bereich besonders vorteilhaft auf die Buntheit der Glaskeramik auswirkt und gleichzeitig eine besonders stabile Keramisierung ermöglicht wird.

Verwendung findet die erfindungsgemäße Glaskeramik als Kochfläche, Kaminsichtscheibe, Grill- oder Bratfläche, Abdeckung von Brennelementen in Gasgrills, Backofensichtscheibe, insbesondere für Pyrolyseherde, Arbeits- oder Tischplatten in Küchen oder Laboren, Abdeckung für Beleuchtungsvorrichtungen, in Brandschutzverglasungen und als Sicherheitsglas, optional im Laminatverbund, als Trägerplatte oder als Ofenauskleidung in thermischen Prozessen oder als rückseitige Abdeckung für mobile elektronische Geräte.

Die erfindungsgemäße Glaskeramik kann insbesondere als Kochfläche eingesetzt werden. Die Kochfläche kann dabei an der Oberseite und/oder der Unterseite ganz oder teilweise mit einem Dekor oder einer funktionellen Beschichtung versehen sein. Ebenso können auf der Unterseite Berührungssensoren zur Bedienung der Kochfläche vorgesehen sein. Dies können beispielsweise aufgedruckte, aufgeklebte oder angedrückte kapazitive Sensoren sein.

Im Folgenden wird die Erfindung anhand von Ausführungsbeispielen weiter veranschaulicht.

Die kristallisierbaren Grüngläser der Ausführungsbeispiele wurden aus in der Glasindustrie üblichen technischen Gemengerohstoffen bei Temperaturen von 1680 °C, 4 Stunden eingeschmolzen. Mit der Wahl solcher Rohstoffe lassen sich die Forderungen nach wirtschaftlichen Rohstoffen und einem geringen Verunreinigungsgehalt an unerwünschten Verunreinigungen vereinbaren. Nach dem Einschmelzen des Gemenges in Tiegeln aus gesintertem Kieselglas wurden die Schmelzen in Pt/Rh-Tiegel mit Innentiegel aus Kieselglas umgegossen und bei Temperaturen von 1640 °C, 60 Minuten durch Rühren homogenisiert. Nach dieser Homogenisierung wurden die Gläser für 3,5 Stunden bei 1680 °C geläutert. Anschließend wurden Stücke von ca. $120 \times 120 \times 30$ mm$^3$ Größe gegossen und in einem Kühlofen beginnend, abhängig von der jeweiligen Viskosität des Glases, ab 650-670 °C mit 30 K/h auf Raumtemperatur abgekühlt, um Spannungen abzubauen. Die Gussstücke wurden in die für die Untersuchungen und für die Keramisierung benötigten Größen unterteilt.

Die Keramisierung der Proben im Grünglaszustand ist mit einem Keramisierungsverfahren mit den folgenden Schritten erfolgt:

a) Aufheizen von Raumtemperatur auf 740 °C innerhalb von 25 Minuten,
b) Halten bei 740°C für 20 Minuten,
c) Erhöhung der Temperatur von 740 °C auf 780 °C innerhalb von 6,5 Minuten,
d) Erhöhung der Temperatur von 780 °C auf 825 °C innerhalb von 20 Minuten,
e) Erhöhung der Temperatur von 825 °C auf 910 °C innerhalb von 8,5 Minuten,
f) Halten der Temperatur bei 910 °C für 10 Minuten,
g) Abkühlen auf Raumtemperatur innerhalb von 125 Minuten.

Dieses Keramisierungsverfahren ist als beispielhaft anzusehen. Es ist möglich die Eigenschaften der Glaskeramik fein zu justieren, indem die Temperaturen und Dauern der einzelnen Schritte variiert werden oder weitere Schritte, zum Beispiel zusätzliche Haltezeiten, hinzugefügt werden.

Die Keramisierung kann beispielsweise auch mit folgenden Parametern erfolgen:

a) Aufheizen von Raumtemperatur auf 680 °C bis 760 °C innerhalb von 3 bis 60 Minuten,

b) Temperaturerhöhung des kristallisierbaren Grünglases auf den Temperaturbereich der Keimbildung $T_a$ bis 800 °C über einen Zeitraum von 10 bis 100 Minuten,

c) Temperaturerhöhung des Kristallisationskeime enthaltenden Glases innerhalb von 5 bis 80 Minuten in den Temperaturbereich hoher Kristallwachstumsgeschwindigkeit von 810 °C bis 930 °C,

d) Halten der Temperatur bei 810 bis 930 °C für 2 bis 60 min.,

e) Abkühlen auf Raumtemperatur innerhalb weniger als 150 Minuten.

Die nachfolgenden Tabellen enthalten die Zusammensetzung und Materialeigenschaften der erfindungsgemäßen Beispiele.

Der thermische Ausdehnungskoeffizient CTE wurde dabei mittels eines Verfahrens ermittelt, das sich im Wesentlichen an der DIN ISO 7991 von 1998 orientiert.

Zur Messung der oberen Entglasungstemperatur (OEG) wurden die Grüngläser in PURh10-Tiegeln geschmolzen. Anschließend wurden die Tiegel für 5 Stunden bei verschiedenen Temperaturen im Bereich der Verarbeitungstemperatur gehalten. Die oberste Temperatur, bei der die ersten Kristalle an der Kontaktfläche der Glasschmelze zur Tiegelwand auftreten, bestimmt die OEG.

Der Verarbeitungspunkt ($T_4$) der Grüngläser wurde mit einem Rührviskosimeter gemäß DIN ISO 7884-2 bestimmt.

Bei der Umwandlung des Grünglases in die Glaskeramik steigt die Dichte an, da die Kristallphase eine höhere Dichte als das amorphe Glas hat. Der sogenannte Schrumpf gibt die lineare Längenänderung bei der Umwandlung des Grünglases in die Glaskeramik an. Der Schrumpf in Prozent wird wie folgt aus der Dichte des Grünglases und der Dichte der Glaskeramik berechnet:

$$Schrumpf = \left(1 - \left(\frac{Dichte_{Grünglas}}{Dichte_{Glaskeramik}}\right)^{\frac{1}{3}}\right) \cdot 100.$$

$T_g$ gibt die Transformationstemperatur, auch als Glasübergangstemperatur bekannt, der Grüngläser an. Sie wird dilatometrisch bestimmt.

Der Lichttransmissionsgrad $\tau_{vis}$ wird im Wellenlängenbereich 380 - 780 nm unter Verwendung von Licht der Normlichtart D65 und einem 2°-Beobachter gemäß den Vorgaben von DIN 5033 bestimmt. Dieser Wert entspricht der Helligkeit Y im CIExyY-Farbraum. Der Wert ist ein Maß für das Helligkeitsempfinden des menschlichen Auges.

Transmissionsspektren wurden gemäß ISO 15368:2021 bestimmt. Tabelle 2 enthält exemplarisch die spektralen Transmissionsgrade "T @ ..." für die Wellenlängen 470 nm, 600 nm, 630 nm, 700 nm, 950 nm und 1600 nm.

Die Farbkoordinaten im CIExyY-Farbraum und im CIELab-Farbraum wurden gemäß den Vorgaben der CIE 1932 mit einem 2°-Beobachter und Licht der Normlichtart D65 in Transmission bestimmt.

Alle Transmissionsmessungen wurden an 4 mm dicken, beidseitig glatten Proben durchgeführt.

Der Volumenanteil "HQMK Phasengehalt" und die Kristallitgröße der kristallinen Phase "HQMK Kristallitgröße" wurden mittels Rietveld-Analyse aus Röntgenbeugungsspektren bestimmt.

Tabelle 1: Zusammensetzungen beispielhafter Glaskeramiken in Gew.-% auf Oxidbasis

| Bsp. Nr. | 1 | 2 | 3 | 4 | 5 | 6 | 7 |
|---|---|---|---|---|---|---|---|
| $SiO_2$ | 64,400 | 64,400 | 65,200 | 64,700 | 64,500 | 66,000 | 64,500 |
| $Al_2O_3$ | 21,170 | 21,170 | 20,090 | 19,980 | 21,170 | 20,160 | 21,150 |

| Li$_2$O | 3,060 | 3,060 | 2,900 | 2,570 | 2,490 | 2,730 | 3,090 |
|---|---|---|---|---|---|---|---|
| Na$_2$O | 0,316 | 0,321 | 0,342 | 0,342 | 0,321 | 0,546 | 0,299 |
| K$_2$O | 0,235 | 0,227 | 0,311 | 0,494 | 0,517 | | 0,227 |
| MgO | 0,375 | 0,377 | 0,338 | 0,332 | 0,076 | 0,142 | 0,371 |
| CaO | 0,952 | 0,440 | 0,822 | 0,621 | 0,947 | 0,012 | 0,435 |
| SrO | 0,014 | 0,017 | 0,014 | 0,014 | 0,013 | 0,014 | 0,017 |
| BaO | 2,550 | 3,030 | 2,510 | 2,710 | 2,540 | 2,600 | 3,070 |
| ZnO | 2,720 | 2,720 | 3,160 | 3,960 | 3,260 | 3,470 | 2,700 |
| TiO$_2$ | 2,231 | 2,233 | 2,336 | 2,344 | 2,228 | 2,342 | 2,231 |
| ZrO$_2$ | 1,840 | 1,850 | 1,820 | 1,820 | 1,840 | 1,820 | 1,850 |
| P$_2$O$_5$ | 0,030 | | | | | | |
| As$_2$O$_3$ | | | | | | | |
| SnO$_2$ | 0,098 | 0,109 | 0,096 | 0,101 | 0,101 | 0,105 | 0,047 |
| Fe$_2$O$_3$ | 0,015 | 0,015 | 0,015 | 0,015 | 0,015 | 0,015 | 0,015 |
| Nd$_2$O$_3$ | | | | | | | |
| MnO$_2$ | 0,001 | | | | | | |
| HfO$_2$ | 0,033 | 0,033 | 0,033 | 0,033 | 0,033 | 0,033 | 0,033 |

Fortsetzung Tabelle 1

| Bsp. Nr. | 8 | 9 | 10 | 11 | 12 | 13 | 14 |
|---|---|---|---|---|---|---|---|
| SiO$_2$ | 63,900 | 62,500 | 65,900 | 64,500 | 64,200 | 64,200 | 64,900 |
| Al$_2$O$_3$ | 21,080 | 23,200 | 19,920 | 21,060 | 21,940 | 21,950 | 21,310 |
| Li$_2$O | 3,020 | 2,470 | 2,740 | 3,070 | 2,740 | 2,710 | 2,690 |
| Na$_2$O | 0,303 | 0,291 | 0,336 | 0,306 | 0,507 | 0,506 | 0,503 |
| K$_2$O | 0,227 | 0,321 | | 0,230 | | | |
| MgO | 0,377 | 0,074 | 0,136 | 0,365 | 0,516 | 0,140 | 0,140 |
| CaO | 0,432 | 0,940 | 0,013 | 0,434 | 0,020 | 0,012 | 0,012 |
| SrO | 0,017 | 0,014 | 0,020 | 0,017 | 0,014 | 0,016 | 0,014 |
| BaO | 3,020 | 2,570 | 3,770 | 3,050 | 2,620 | 3,010 | 2,640 |
| ZnO | 2,700 | 3,410 | 2,830 | 2,700 | 3,110 | 3,090 | 3,470 |
| TiO$_2$ | 2,222 | 2,228 | 2,352 | 2,231 | 2,340 | 2,335 | 2,350 |
| ZrO$_2$ | 1,830 | 1,850 | 1,840 | 1,850 | 1,830 | 1,830 | 1,830 |
| P$_2$O$_5$ | | | | | | | |

| | | | | | | | |
|---|---|---|---|---|---|---|---|
| $As_2O_3$ | 0,830 | | | | | | |
| $SnO_2$ | | 0,101 | 0,106 | 0,103 | 0,112 | 0,113 | 0,109 |
| $Fe_2O_3$ | 0,014 | 0,014 | 0,015 | 0,014 | 0,014 | 0,015 | 0,014 |
| $Nd_2O_3$ | | | | 0,051 | | | |
| $MnO_2$ | | | | | | | |
| $HfO_2$ | 0,032 | 0,032 | 0,033 | 0,033 | 0,032 | 0,032 | 0,032 |

Tabelle 2: Materialeigenschaften der beispielhaften Glaskeramiken

| Bsp. Nr. | | 1 | 2 | 3 | 4 | 5 | 6 |
|---|---|---|---|---|---|---|---|
| $T_g$ | °C | 685 | 685 | 678 | 680 | 686 | 689 |
| Dichte Glas | g/cm³ | 2,5121 | 2,5143 | 2,5106 | 2,5267 | 2,5174 | 2,5036 |
| $T_4$ | °C | 1305 | 1307 | | | | 1328 |
| OEG | °C | 1275 | 1285 | | | | 1315 |
| HQMK Phasengehalt | Vol.-% | 62 | 59 | 59 | 57 | 54 | 61 |
| HQMK Kristallitgröße | nm | 47 | 41 | 47 | 53 | 42 | 36 |
| Dichte Glaskeramik | g/cm³ | 2,5759 | 2,5796 | 2,5779 | 2,5872 | 2,5815 | 2,5820 |
| Schrumpf | % | 0,833 | 0,851 | 0,878 | 0,786 | 0,835 | 1,023 |
| CTE(20;700°C) | ppm/K | 0,16 | 0,12 | 0,15 | 0,26 | 0,31 | -0,26 |
| $\tau_{vis}$ | % | 85,2 | 86,3 | 83,9 | 80,9 | 84,6 | 85,9 |
| L* | | 94,0 | 94,4 | 93,4 | 92,1 | 93,7 | 94,3 |
| a* | | -0,1 | -0,2 | -0,2 | -0,2 | 0,0 | -0,3 |
| b* | | 5,0 | 4,6 | 6,3 | 8,9 | 5,1 | 4,9 |
| C* | | 5,0 | 4,6 | 6,3 | 8,9 | 5,1 | 4,9 |
| T @ 400 nm | % | 67,4 | 69,0 | 60,8 | 52,8 | 69,5 | 67,0 |
| T @ 470 nm | % | 80,4 | 81,9 | 78,0 | 72,7 | 79,5 | 81,2 |
| T @ 600 nm | % | 87,1 | 88,0 | 86,3 | 84,2 | 86,7 | 87,6 |
| T @ 630 nm | % | 87,9 | 88,7 | 87,4 | 85,6 | 87,6 | 88,3 |
| T @ 700 nm | % | 89,2 | 89,9 | 88,9 | 87,8 | 89,0 | 89,5 |
| T @ 950 nm | % | 90,0 | 90,1 | 89,7 | 89,4 | 89,5 | 89,9 |
| T @ 1600 nm | % | 89,3 | 89,3 | 89,2 | 89,2 | 89,0 | 89,1 |

Fortsetzung Tabelle 2

| Bsp. Nr. | | 7 | 8 | 9 | 10 | 11 | 12 |
|---|---|---|---|---|---|---|---|
| $T_g$ | °C | 683 | 681 | 694 | 697 | 682 | 692 |
| Dichte Glas | g/cm³ | 2,5124 | 2,5199 | 2,5359 | 2,5106 | 2,5133 | 2,5165 |
| $T_4$ | °C | | | | | | |
| OEG | °C | | | | | | |
| HQMK-Phasengehalt | Vol.-% | 60 | 61 | 52 | 58 | 61 | 61 |
| HQMK Kristallitgröße | nm | 45 | 53 | 37 | 39 | 44 | 43 |
| Dichte Glaskeramik | g/cm³ | 2,5780 | 2,5859 | 2,5977 | 2,5893 | 2,5795 | 2,5943 |
| Schrumpf | % | 0,856 | 0,858 | 0,799 | 1,024 | 0,863 | 1,010 |
| CTE (20;700°C) | ppm/K | 0,10 | 0,11 | 0,38 | -0,10 | 0,11 | 0,22 |
| $\tau_{vis}$ | % | 86,3 | 88,7 | 77,6 | 86,8 | 84,9 | 85,1 |
| L* | | 94,4 | 95,5 | 90,6 | 94,7 | 93,8 | 93,9 |
| a* | | 0,1 | -0,3 | 0,1 | -0,3 | -0,2 | 0,0 |
| b* | | 3,8 | 3,2 | 9,2 | 4,2 | 3,7 | 4,1 |
| C* | | 3,8 | 3,2 | 9,2 | 4,2 | 3,7 | 4,1 |
| T @ 400 nm | % | 74,4 | 77,0 | 55,5 | 69,8 | 69,3 | 71,7 |
| T @ 470 nm | % | 82,4 | 85,6 | 69,0 | 82,9 | 81,5 | 81,0 |
| T @ 600 nm | % | 87,9 | 89,8 | 81,2 | 88,4 | 86,8 | 86,8 |
| T @ 630 nm | % | 88,7 | 90,3 | 82,7 | 88,9 | 88,5 | 87,6 |
| T @ 700 nm | % | 89,7 | 90,7 | 85,4 | 89,9 | 89,6 | 88,7 |
| T @ 950 nm | % | 89,8 | 90,1 | 88,8 | 90,0 | 89,9 | 89,8 |
| T @ 1600 nm | % | 89,5 | 89,8 | 89,1 | 89,6 | 89,6 | 89,0 |

Fortsetzung Tabelle 2

| Bsp. Nr. | | 13 | 14 |
|---|---|---|---|
| $T_g$ | °C | | |
| Dichte Glas | g/cm³ | | |
| $T_4$ | °C | | |

| OEG | °C | | |
|---|---|---|---|
| HQMK Phasengehalt | Vol.-% | 60 | 62 |
| HQMK Kristallitgröße | nm | 40 | 40 |
| Dichte Glaskeramik | g/cm³ | | |
| Schrumpf | % | | |
| CTE(20;700°C) | ppm/K | | |
| $\tau_{vis}$ | % | 85,5 | 84,7 |
| L* | | 94,1 | 93,8 |
| a* | | 0,0 | -0,1 |
| b* | | 4,0 | 4,6 |
| C* | | 4,0 | 4,6 |
| T @ 400 nm | % | 72,9 | 69,2 |
| T @ 470 nm | % | 81,4 | 80,2 |
| T @ 600 nm | % | 87,1 | 86,5 |
| T @ 630 nm | % | 87,8 | 87,3 |
| T @ 700 nm | % | 88,9 | 88,6 |
| T @ 950 nm | % | 89,9 | 89,6 |
| T @ 1600 nm | % | 89,2 | 89,2 |

**Patentansprüche**

1.  Transparente Lithiumaluminiumsilikat-Glaskeramik

    mit einem thermischen Ausdehnungskoeffizienten im Bereich von 20 °C bis 700 °C von -0,8 bis 1,5 ppm/K,
    mit einem Lichttransmissionsgrad $\tau_{vis}$ von mehr als 75 % bezogen auf eine Dicke von 4 mm und einer Buntheit C*
    von weniger als 10 bezogen auf eine Dicke von 4 mm und
    mit einer Zusammensetzung enthaltend in Gew.-% auf Oxidbasis:

    | | |
    |---|---|
    | $SiO_2$ | 62 - 68 |
    | $Al_2O_3$ | 19 - 24 |
    | $Li_2O$ | 2,4 - 3,1 |
    | BaO | > 2,5 |
    | ZnO | > 2,5 |
    | $ZrO_2$ | > 1,5 |
    | $Na_2O$ | 0 - 1 |

(fortgesetzt)

| | |
|---|---|
| $K_2O$ | 0 - 1. |

2. Transparente Lithiumaluminiumsilikat-Glaskeramik nach Anspruch 1, **dadurch gekennzeichnet, dass** die Glaskeramik bis auf unvermeidbare Verunreinigungen frei von $Cr_2O_3$, $V_2O_5$, $MnO_2$ und MoOs ist.

3. Transparente Lithiumaluminiumsilikat-Glaskeramik nach Anspruch 1 oder 2, **dadurch gekennzeichnet, dass** die transparente Lithiumaluminiumsilikat-Glaskeramik weniger als 3,0 Gew.-% $TiO_2$ enthält, bevorzugt weniger als 2,7 Gew.-%, besonders bevorzugt weniger als 2,5 Gew.-%, ganz besonders bevorzugt weniger als 2,4 Gew.-%.

4. Transparente Lithiumaluminiumsilikat-Glaskeramik nach einem der vorherigen Ansprüche, **dadurch gekennzeichnet, dass** die transparente Lithiumaluminiumsilikat-Glaskeramik weniger als 0,05 Gew.-% $Fe_2O_3$ enthält, bevorzugt weniger als 0,04 Gew.-%, besonders bevorzugt weniger als 0,03 Gew.-%, ganz besonders bevorzugt weniger als 0,02 Gew.-%.

5. Transparente Lithiumaluminiumsilikat-Glaskeramik nach einem der vorherigen Ansprüche, **dadurch gekennzeichnet, dass** die transparente Lithiumaluminiumsilikat-Glaskeramik weniger als 1,2 Gew.-% MgO enthält, bevorzugt weniger als 1,0 Gew.-%, besonders bevorzugt weniger als 0,8 Gew.-%, ganz besonders bevorzugt weniger als 0,5 Gew.-%.

6. Transparente Lithiumaluminiumsilikat-Glaskeramik nach einem der vorherigen Ansprüche, **dadurch gekennzeichnet, dass** die transparente Lithiumaluminiumsilikat-Glaskeramik weniger als 1,2 Gew.-% CaO enthält, bevorzugt weniger als 1,0 Gew.-%, besonders bevorzugt weniger als 0,8 Gew.-%, ganz besonders bevorzugt weniger als 0,5 Gew.-%.

7. Transparente Lithiumaluminiumsilikat-Glaskeramik nach einem der vorherigen Ansprüche, **dadurch gekennzeichnet, dass** die transparente Lithiumaluminiumsilikat-Glaskeramik weniger als 0,2 Gew.-% $SnO_2$ enthält, bevorzugt weniger als 0,15 Gew.-%, besonders bevorzugt weniger als 0,1 Gew.-%.

8. Transparente Lithiumaluminiumsilikat-Glaskeramik nach einem der vorherigen Ansprüche, **dadurch gekennzeichnet, dass** die transparente Lithiumaluminiumsilikat-Glaskeramik bis auf unvermeidbare Verunreinigungen frei von $SnO_2$ ist und 0,5 Gew.-% bis 1,5 Gew.-% $As_2O_3$ und/oder $Sb_2O_3$ enthält.

9. Transparente Lithiumaluminiumsilikat-Glaskeramik nach einem der vorherigen Ansprüche, **dadurch gekennzeichnet, dass** die transparente Lithiumaluminiumsilikat-Glaskeramik 0,01 - 0,07 Gew.-% $Nd_2O_3$ enthält.

10. Transparente Lithiumaluminiumsilikat-Glaskeramik nach Anspruch 7 oder 8, **dadurch gekennzeichnet, dass** die transparente Lithiumaluminiumsilikat-Glaskeramik in Gew.-% auf Oxidbasis enthält:

| | |
|---|---|
| $SiO_2$ | 62 - 67 |
| $Al_2O_3$ | 19 - 23 |
| $Li_2O$ | 2,4 - 3,1 |
| $Na_2O$ | 0 - 1 |
| $K_2O$ | 0 - 1 |
| MgO | 0 - 1 |
| CaO | 0 - 1,2 |
| BaO | > 2,5 |
| ZnO | > 2,5 |
| $TiO_2$ | < 3,0 |
| $ZrO_2$ | > 1,5. |

11. Transparente Lithiumaluminiumsilikat-Glaskeramik nach einem der vorherigen Ansprüche, **dadurch gekennzeichnet, dass** die transparente Lithiumaluminiumsilikat-Glaskeramik in der Hochquarz-Mischkristallphase eine Kristallitgröße von weniger als 80 nm aufweist.

12. Transparente Lithiumaluminiumsilikat-Glaskeramik nach einem der vorherigen Ansprüche, **dadurch gekennzeichnet, dass** das Verhältnis von $Al_2O_3$ zu $TiO_2$ im Bereich 7 bis 12, bevorzugt im Bereich 8 bis 11, besonders bevorzugt im Bereich 8,5 bis 10,5.

13. Verwendung einer Glaskeramik nach einem der vorhergehenden Ansprüche als Kochfläche, Kaminsichtscheibe, Grill- oder Bratfläche, Abdeckung von Brennelementen in Gasgrills, Backofensichtscheibe, insbesondere für Pyrolyseherde, Arbeits- oder Tischplatten in Küchen oder Laboren, Abdeckung für Beleuchtungsvorrichtungen, in Brandschutzverglasungen und als Sicherheitsglas, optional im Laminatverbund, als Trägerplatte oder als Ofenauskleidung in thermischen Prozessen oder als rückseitige Abdeckung für mobile elektronische Geräte.

Europäisches
Patentamt

European
Patent Office

Office européen
des brevets

# EUROPÄISCHER RECHERCHENBERICHT

**Nummer der Anmeldung**

**EP 23 18 6427**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 4 851 372 A (LINDIG OTTO [DE] ET AL) 25. Juli 1989 (1989-07-25) | 1-8, 10-13 | INV. C03C3/087 |
| Y | * Ansprüche; Beispiele * | 9 | C03C3/095 C03C3/097 |
| X | DE 20 2022 106821 U1 (SCHOTT AG [DE]) 22. Dezember 2022 (2022-12-22) * Absätze [0001], [0014] – [0089]; Ansprüche; Beispiele * | 1-13 | C03C10/14 |
| Y | US 2012/302422 A1 (SIEBERS FRIEDRICH [DE] ET AL) 29. November 2012 (2012-11-29) * Absätze [0038] – [0040]; Ansprüche; Beispiele * | 9 | |

**RECHERCHIERTE SACHGEBIETE (IPC)**

**C03C**

Der vorliegende Recherchenbericht wurde für alle Patentansprüche erstellt

| Recherchenort | Abschlußdatum der Recherche | Prüfer |
|---|---|---|
| **München** | **15. Dezember 2023** | **Wrba, Jürgen** |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
...........................................................................................
& : Mitglied der gleichen Patentfamilie, übereinstimmendes
Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 23 18 6427

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-12-2023

| Im Recherchenbericht angeführtes Patentdokument | Datum der Veröffentlichung | Mitglied(er) der Patentfamilie | | Datum der Veröffentlichung |
|---|---|---|---|---|
| US 4851372 A | 25-07-1989 | FR | 2564823 A1 | 29-11-1985 |
| | | GB | 2159514 A | 04-12-1985 |
| | | JP | H0377137 B2 | 09-12-1991 |
| | | JP | S60255645 A | 17-12-1985 |
| | | US | 4851372 A | 25-07-1989 |
| DE 202022106821 U1 | 22-12-2022 | KEINE | | |
| US 2012302422 A1 | 29-11-2012 | AT | E469106 T1 | 15-06-2010 |
| | | CN | 101269910 A | 24-09-2008 |
| | | EP | 1837312 A1 | 26-09-2007 |
| | | ES | 2344267 T3 | 23-08-2010 |
| | | JP | 5367952 B2 | 11-12-2013 |
| | | JP | 2007254279 A | 04-10-2007 |
| | | US | 2009018007 A1 | 15-01-2009 |
| | | US | 2012302422 A1 | 29-11-2012 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2012010341 A1
- EP 3502069 A1
- US 2017050880 A
- US 2020189965 A
- US 2020140322 A
- US 2021387899 A
- WO 2021224412 A1
- DE 202022106826 U1